# EUROPÄISCHE PATENTANMELDUNG

(11) **EP 1 215 319 A2**
(43) Veröffentlichungstag der Anmeldung: **19.06.2002**
(21) Anmeldenummer: 01126729.1
(22) Anmeldetag: 09.11.2001
(51) Int. Cl.: D03D 15/00, D03D 15/02

(54) **Flächiges Gewebeelement**

(30) Priorität: 16.12.2000 DE 20021305 U
(71) Anmelder: FIRMA HAVER & BOECKER, D-59302 Oelde (DE)
(72) Erfinder: Lütke-Föller, Heinz, verstorben (DE); Butenkemper, Stefan, 59320 Ennigerloh (DE)
(74) Vertreter: Dantz, Jan Henning

(57) **Zusammenfassung**

Ein flächiges Drahtgewebeelement, welches aus Kett- und quer dazu verlaufenden Schußfäden (11, 12) besteht, und diese Fäden (11, 12) nach einer Bindungsart miteinander fixiert sind, soll so gestaltet werden, daß bestimmte Fäden je nach Verwendungszweck des Drahtgewebeelementes entweder vereinzelt oder in einer anderen Reihenfolge gleichbleibend erfaßt werden können, um sie danach zu verbinden und zu isolieren oder an andere Bauteile anzuschließen. Darüber hinaus soll gewährleistet sein, daß das Drahtgewebeelement (10) mittels bekannter Handhabungsgeräte weiterverarbeitet werden kann.

Erfindungsgemäß bestehen die in einer Richtung verlaufenden Fäden (12) aus einem elektrisch leitfähigen Material, während die quer dazu verlaufenden Fäden (11) aus einem elektrisch leitfähigem Material und einer isolierenden Umhüllung oder vollständig aus einem elektrisch isolierenden Werkstoff. Die Anordnung ist so gewählt, daß zwei sich gegenüberliegende Randbereiche des flächigen Gewebeelementes (10) angrenzenden Streifen (14,15) sind in einer anderen Bindungsart ausgeführt wie der dazwischen liegende mittlere Bereich (13), so daß zumindest eine vorbestimmte Anzahl von elektrisch leitfähigen Fäden innerhalb der äußeren Randbereiche zusammenführbar sind.

Das flächige Gewebeelement ist besonders für die Produktion von elektronischen Artikeln geeignet.

## Beschreibung

Die Erfindung bezieht sich auf ein flächiges Gewebeelement, insbesondere auf ein Drahtgewebeelement, welches aus Kett- und quer dazu verlaufenden Schußfäden besteht, und diese Fäden nach einer Bindungsart miteinander fixiert sind.

Gewebe sind allgemein bekannt und werden vielseitig eingesetzt. Sie bestehen aus zwei miteinander verbundenen Fadensystemen, die sich normalerweise im rechten Winkel kreuzen. Die eine Fadenrichtung verläuft in der Längsrichtung des Gewebes und diese Fäden werden als Kettfäden bezeichnet. Demzufolge sind die Kettfäden so lang wie das Gewebeelememt. Die zweite Fadengruppe liegt in der die Breite des Gewebeelementes bestimmenden Richtung. Diese Fäden werden als Schußfäden bezeichnet. Die nach bestimmten Regeln durchgeführte Verkreuzung der beiden Fadensysteme, bei der die Schußfäden teils über und teils unter den Kettfäden liegen, führt zu der Bindungsart. Sehr bekannt ist die sogenannte Leinenbindung und die Köperbindung. Außerdem gibt es davon abgeleitete Varianten in den verschiedenstes Ausführungen. Bei der Leinenbindung verläuft ein Schußfaden im ständigen Wechsel ober- und unterhalb der Kettfäden, wobei der in Richtung der Kettfäden gesehen, der jeweils nächste Schußfaden an der anderen Seite der Kettfäden liegt. Bei der sogenannten Köperbindung überspringen die Kettfäden mindestens zwei Schußfäden, wobei der nächst folgende Schußfaden oberhalb des Kettfadens liegt. Die oben liegenden Teile der Kettfäden stehen außerdem im Versatz zueinander.

Insbesondere aus Drahtgewebeelementen werden Bauteile der unterschiedlichsten Art hergestellt. Neuerdings werden sie auch im Bereich der Elektronik verwendet. Es ist dann notwendig, daß das Gewebeelement entsprechend den Anforderungen ausgelegt wird.

Der Erfindung liegt die Aufgabe zugrunde, einen flächiges Gewebeelement der eingangs näher beschriebenen Art so zu gestalten, daß bestimmte Fäden je nach Verwendungszweck des Gewebeelementes entweder vereinzelt oder in einer anderen Reihenfolge gleichbleibend erfaßt werden können, um sie danach zu verbinden oder zu isolieren oder an andere Bauteile anzuschließen. Darüber hinaus soll gewährleistet sein, daß das Gewebeelement mittels bekannter Handhabungsgeräte weiter verarbeitet werden kann.

Die gestellte Aufgabe wird gelöst, indem die in einer Richtung verlaufenden Fäden aus einem elektrisch leitfähigem Material bestehen, die quer dazu verlaufenden Fäden aus einem elektrisch leitfähigem Material und einer isolierenden Umhüllung oder vollständig aus einem elektrisch isolierenden Werkstoff bestehen, und daß zwei sich gegenüberliegende Randbereiche des Gewebeelementes ausschließlich aus den elektrisch leitfähigen Fäden bestehen.

Da die in einer Richtung verlaufenden Fäden nunmehr gegeneinander isoliert sind, können die anderen Fäden mit elektrischer Energie durchflutet werden. Dadurch ergeben sich vielfältige Möglichkeiten zum Einsatz des flächigen Gewebeelementes. Da in den beiden gegenüberliegenden Randbereichen entweder nur Kettfäden oder nur Schußfäden vorhanden sind, ist eine Anpassung an die Verwendung möglich. So können die Drähte einzeln genutzt werden. Es können jedoch auch zwei oder mehr als zwei Drähte oder Fäden miteinander verbunden werden, wobei die Anzahl der miteinander verbundenen Drähte oder Fäden nach einem bestimmten Schema vorgenommen werden kann. Sie können im Bedarfsfalle auch isoliert werden oder an andere Bauteile angeschlossen werden.

Die Vereinzelung der Fäden und auch das Zusammenführen von Fäden nach einem vorgegebenen Schema wird erleichtert, wenn an die ausschließlich aus Fäden einer Richtung gebildeten Randbereiche angrenzenden Streifen des Gewebeelementes in einer anderen Bindungsart ausgeführt sind als der dazwischen liegende mittlere Bereich, so daß zumindest eine vorbestimmte Anzahl von elektrisch leitfähigen Fäden innerhalb der äußeren Randbereiche zusammenführbar sind. Der mittlere Bereich des Gewebeelementes kann dann aus einer Bindungsart bestehen, die für die Funktion des Gewebeelementes optimal ist, während für die angrenzenden Streifen diejenige Bindungsart verwendet werden kann, die zur Vereinzelung der Fäden bzw. zum Zusammenführen optimal ist. Es ist nicht zwingend, daß der mittlere Bereich in einer Bindungsart ausgeführt ist, da auch dieser Bereich in mehreren von einander abweichenden Bindungsarten ausgeführt werden kann. In einer Ausführungsform ist es vorgesehen, daß die beiden freien Randbereiche ca. 40 %, die angrenzenden Streifen ca. 20 % und der mittlere Bereich widerum 40 % der Breite bzw. Länge des Gewebeelementes ausmacht, je nach dem ob die Randbereiche frei von Schuß- oder Kettfäden sind. Diese Angaben sind beispielhaft zu sehen, da die wahren Längen der Randbereiche und der angrenzenden Streifen bei einer Vergrößerung oder Verkleinerung der Länge bzw. Breite des Gewebeelementes gleich bleiben können, so daß der mittlere Bereich der Länge bzw. Breite des Gewebeelementes abhängt.

In einer bevorzugten Ausführungsform ist vorgesehen, daß die Schußfäden aus einem elektrisch leitfähigen Material und die Kettfäden aus einem elektrisch leitfähigem Material und aus einer Umhüllung aus einem elektrisch isolierendem Material oder vollständig aus einem elektrisch isolierenden Werkstoff bestehen. Diese Ausführung ist besonders vorteilhaft für die Herstellung des flächigen Gewebeelementes. Es ist ferner vorgesehen, daß die beiden an die äußeren Randbereiche angrenzenden Streifen in einer Köperbindung und der dazwischen liegende Bereich in einer Leinenbindung oder in mehreren Bindungsarten ausgeführt sind. Durch die Köperbindung der an die Randbereiche angrenzende Streifen wird die Vereinzelung bzw. das Zusammenführen der Fäden vereinfacht. So läßt sich die Anzahl der zusammenzuführenden elektrisch leitfähigen Drähte aus der Ausführungsform der Köperbindung der an die äußeren Randbereiche angrenzenden Streifen variieren. Beispielsweise könnte bei einer sogenannten 5+1-Bindung wechselweise 5 Fäden zusammengeführt und der nächst folgende Faden könnte als Einzelfaden benutzt werden. Es könnten jedoch auch bei einer entsprechenden Bindung die Anzahl der zusammengeführten Fäden, in Richtung der isolierten Fäden gesehen, unterschiedlich sein. In einer anderen Ausführungsform könnten die die Schußfäden über- und untergreifenden Abschnitte der Kettfäden in den beiden in der Köperbindung ausgeführten Streifen in einem Versatz, vorzugsweise um einen Schußfaden, zueinander bestehen. Die Köperbindung der Streifen sollte dann so ausgeführt sein, daß in jedem äußeren Bereich zwei Fäden aus elektrisch leitenden Material zusammengeführt werden, wobei durch den Versatz um jeweils einen Schußfaden auf der anderen Seite sinngemäß ein endloser Schußfaden hergestellt wird, der dann in einem Isoliergewebe als Widerstandsdraht genutzt werden kann.

Anhand der beiliegenden Zeichnungen wird die Erfindung noch näher erläutert.

Es zeigen:

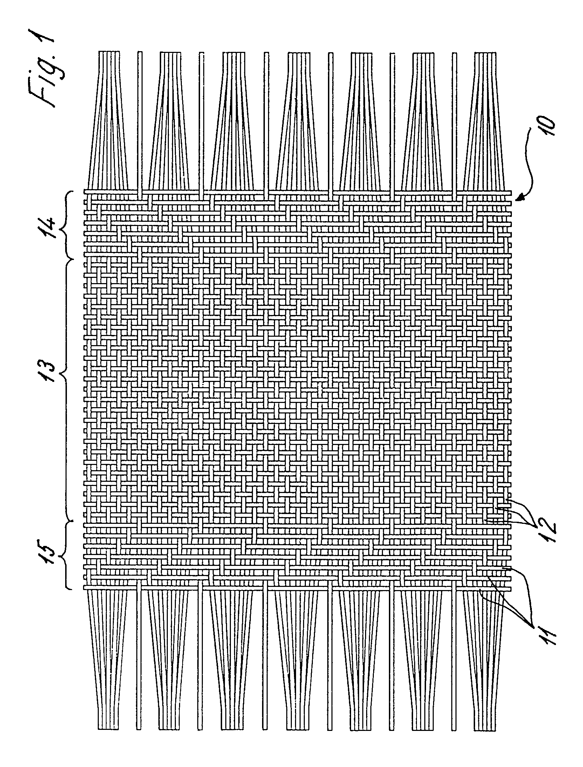

- Figuren 1 - 3: das erfindungsgemäße flächige Gewebeelement in drei verschiedenen Ausführungen.

Die in den Figuren 1 - 3 dargestellten flächigen Gewebeelement 10 sind aus Darstellungsgründen vergrößert dargestellt. Jedes flächige Gewebeelemente 10 besteht aus einer Vielzahl von Kettfäden 11 und aus quer- bzw. im rechten Winkel dazu verlaufenden Schußfäden 12. Die Kettfäden 11 und die Schußfäden 12 verlaufen jeweils parallel und im Abstand zueinander. Die Kettfäden 11 und die Schußfäden 12 bestehen aus Metall, so daß sie elektrisch leitend sind. Die Kettfäden 11 sind jedoch in nicht dargestellter Weise mit einer Umhüllung aus einem elektrisch nicht leitfähigen Material versehen. Ein derartiges Material wäre beispielsweise ein Kunststoff. In den dargestellten Ausführungsbeispielen sind die Endbereiche der Schußfäden 12 vereinzelt, dh., sie erstrecken sich über die beiden äußeren Kettfäden 11 hinaus. Die freien Endbereiche aller Schußfäden 12 sind nach einem vorbestimmten Schema zusammengeführt, wobei bestimmte Schußfäden 12 auch einzeln verlaufen. Die freien Enden der Schußfäden 12 können je nach Verwendungszweck des flächigen Gewebeelementes 10 mit anderen Bauteilen elektrisch verbunden werden, sie können jedoch auch isoliert oder mit Anschlüssen versehen werden. Der mittlere Bereich 13 des Gewebeelementes 10 ist im dargestellten Ausführungsbeispiel in der sogenannten Leinenbindung ausgeführt, daß heißt, die Kett- und Schußfäden 11, 12 sind im ständigen Wechsel unter die jeweils querverlaufenden Fäden 11 oder 12 geführt. Beidseitig an den mittleren Bereich schließen sich zwei Streifen 14, 15 an, die in einer Köperbindung ausgeführt sind. Im dargestellten Ausführungsbeispiel sind diese Streifen 14, 15 in einer 5-1-Bindung ausgeführt, dh., die Kettfäden 11 überspringen an der Oberseite 5 Schußfäden, während der nächst folgende Schußfaden 12 oben liegt. Diese Schußfäden werden einzeln in die Randbereiche geführt, während die anderen 5 Fäden zusammengeführt sind. Diese Ausführung ist in der Figur 1 dargestellt. Die Streifen 14, 15 werden gemäß der Figur 1 durch 7 Kettfäden 11 gebildet. Es ergibt sich aus der Figur, daß das Vereinzeln bzw. das Zusammenführen der Endbereiche der Schußfäden 12 durch die Köperbindung erleichtert wird.

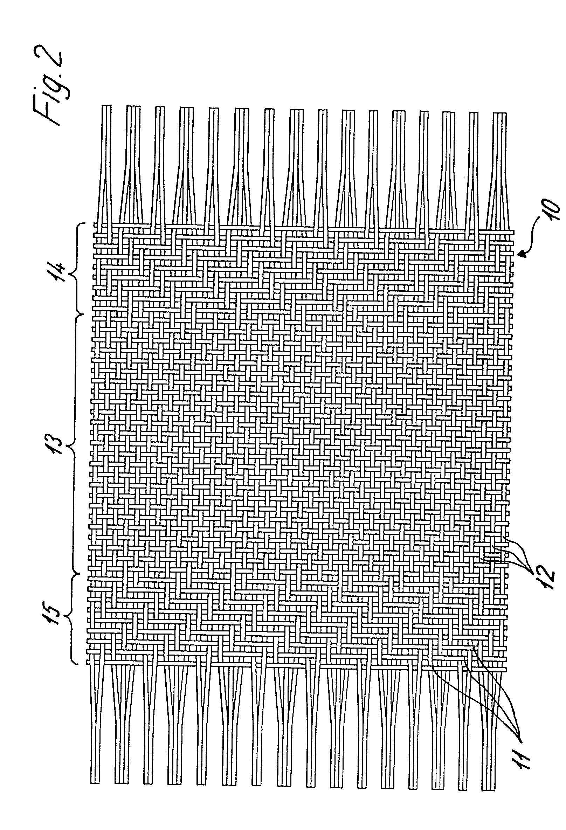

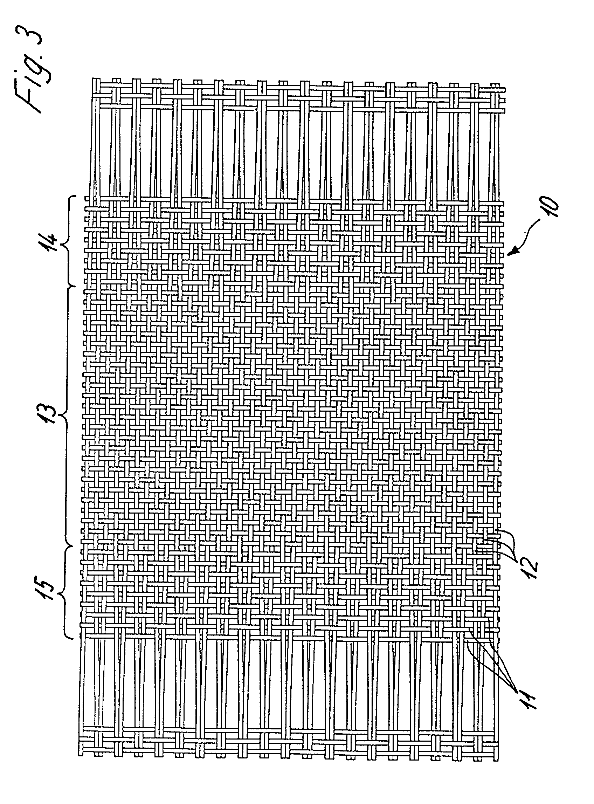

Bei der Ausführung nach der Figur 2 ist der mittlere Bereich 13 identisch zu der Ausführung nach der Figur 1, dh., in einer Leinenbindung ausgeführt. Die Streifen 14, 15 sind ebenfalls in einer Köperbindung ausgeführt, jedoch werden die Streifen aus 9 Kettfäden 11 gebildet und die Bindung ist eine sogenannte 3-2-Bindung, dh., die Kettfäden 11 überspringen 3 Schußfäden 12 und die beiden nächstfolgenden Schußfäden liegen über den Kettfäden 11. Die Enden der Schußfäden 12 werden zusammengeführt, wobei im ständigen Wechsel 3 und 2 Schußfäden zusammengeführt werden. Bei der Ausführung nach der Figur 3 sind die Streifen 14, 15 widerum in einer Köperbindung ausgeführt, jedoch in einer sogenannten 2-2-Bindung, dh., die Kettfäden 11 werden wechselweise über und unter 2 Schußfäden 12 geführt. Demzufolge werden jeweils 2 Schußfäden 12 mit ihren Endbereichen zusammengeführt. Aus der Figur 3 ergibt sich, daß darüber hinaus noch eine Verschiebung der Kettfäden zwischen den beiden Streifen 14, 15 um jeweils einen Schußfaden 12 stattfindet Dadurch werden die Schußfäden 12 sinngemäß endlos. Die Schußfäden 12 können dann in einem Isoliergewebe als Widerstandsdraht genutzt werden. Sofern das Gewebeelement ein Drahtgewebeelement ist, bestehen die Kett- und Schußfäden aus metallischen Drähten.

Die Kett- und Schußfäden 11, 12 bestehen aus Drähten mit einem relativ geringen Durchmesser, so daß das Gewebe auch als Feingewebe bezeichnet werden kann. Die Erfindung ist nicht auf die dargestellten Ausführungesbeispiele beschränkt. Wesentlich ist, daß durch die äußeren Kettfäden 11 Streifen 14, 15 in einer solchen Bindung gegeben sind, daß die Vereinzelung oder das Zusammenführen der Enden der Schußfäden 12 durch die Bindungsart vorgegeben wird.

## Patentansprüche

1. Flächiges Gewebeelement, insbesondere Drahtgewebeelement, welches aus Kett- und quer dazu verlaufenden Schußfäden besteht, und diese Fäden nach einer Bindungsart miteinander fixiert sind, **dadurch gekennzeichnet, daß** die in einer Richtung verlaufenden Fäden (12) aus einem elektrisch leitfähigen Material bestehen, die quer dazu verlaufenden Fäden (11) aus einem elektrisch leitfähigen Material und einer isolierenden Umhüllung oder vollständig aus einem elektrisch isolierenden Werkstoff bestehen, und daß zwei sich gegenüberliegende Randbereiche des flächigen Gewebeelementes (10) ausschließlich aus den elektrisch leitfähigen Fäden (12) bestehen.

2. Flächiges Gewebeelement nach Anspruch 1, **dadurch gekennzeichnet, daß** die an die aus Fäden gebildeten Randbereiche des flächiges Gewebeelementes (10) angrenzenden Streifen (14, 15) in einer anderen Bindungsart ausgeführt sind wie der dazwischen liegende mittlere Bereich (13), so daß zumindest eine vorbestimmte Anzahl von elektrisch leitfähigen Fäden innerhalb der äußeren Randbereiche zusammenführbar sind.

3. Flächiges Gewebeelement nach Anspruch 2, **dadurch gekennzeichnet, daß** die aus einzelnen Fäden gebildeten Randbereiche ca. 40 %, das die Streifen (14, 15) ca. 20 % und das der mittlere Bereich (13) ca. 40 % der Gesamtbreite bzw. der Gesamtlänge des flächigen Gewebeelementes (10) beträgt.

4. Flächiges Gewebeelement nach Anspruch 1, **dadurch gekennzeichnet, daß** die Schußfäden (12) aus einem elektrisch leitfähigen Material und die Kettfäden (11) aus einem elektrisch leitfähigen Material und aus einer Umhüllung aus einem elektrisch isolierendem Material oder vollständig aus einem elektrisch isolierendem Material bestehen.

5. Flächiges Gewebeelement nach Anspruch 2, **dadurch gekennzeichnet, daß** die beiden an die aus den einzelnen Fäden gebildeten Randbereiche angrenzenden Streifen (14, 15) des Gewebeelementes (10) in einer Köperbindung und der dazwischen liegende Bereich in einer Leinenbindung ausgeführt sind.

6. Flächiges Gewebeelement nach Anspruch 5, **dadurch gekennzeichnet, daß** die Anzahl der zusammenzuführenden elektrisch leitfähigen Fäden (12) sich aus der Ausführungsform der Köperbindung der beiden Streifen (14, 15) ergibt.

7. Flächiges Gewebeelement nach einem oder mehreren der vorhergehenden Ansprüche 1 - 6, **dadurch gekennzeichnet, daß** die Anzahl der zusammenzuführenden Fäden, in Richtung der isolierten Fäden (11) gesehen unterschiedlich ist.

8. Flächiges Gewebeelement nach einem oder mehreren der vorhergehenden Ansprüche 1 - 7, **dadurch gekennzeichnet, daß** die die Schußfäden (12) über- und untergreifenden Abschnitte der Kettfäden (11) der in der Köperbindung ausgeführten Streifen (14, 15) in einem Versatz, vorzugsweise um einen Schußfaden, zueinander stehen.
